(19) Europäisches Patentamt / European Patent Office / Office européen des brevets

(11) **EP 2 975 643 B1**

(12) **FASCICULE DE BREVET EUROPEEN**

(45) Date de publication et mention
de la délivrance du brevet:
**21.08.2019   Bulletin 2019/34**

(51) Int Cl.:
***H01L 27/144*** *(2006.01)*      ***H01L 27/146*** *(2006.01)*

(21) Numéro de dépôt: **15176764.7**

(22) Date de dépôt: **15.07.2015**

(54) **MATRICE DE PHOTODIODES CDHGTE A FAIBLE BRUIT**

RAUSCHARME CDHGTE-FOTODIODENMATRIX

LOW-NOISE CDHGTE PHOTODIODE ARRAY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:   **16.07.2014   FR 1401585**

(43) Date de publication de la demande:
**20.01.2016   Bulletin 2016/03**

(73) Titulaire: **Commissariat à l'Énergie Atomique et aux Énergies Alternatives
75015 Paris (FR)**

(72) Inventeurs:
 • **MOLLARD, Laurent
   38640 CLAIX (FR)**
 • **BOULARD, François
   38000 GRENOBLE (FR)**
 • **BOURGEOIS, Guillaume
   38000 GRENOBLE (FR)**

(74) Mandataire: **Brevalex
   56, Boulevard de l'Embouchure
   B.P. 27519
   31075 Toulouse Cedex 2 (FR)**

(56) Documents cités:
**EP-A1- 2 752 893     US-A- 4 961 098
US-A- 5 880 510**

EP 2 975 643 B1

**Description**

**DOMAINE TECHNIQUE**

La présente invention concerne le domaine des photodiodes infrarouges en CdHgTe, utilisées pour détecter un rayonnement infrarouge.

**ÉTAT DE LA TECHNIQUE ANTÉRIEURE**

On connaît dans l'art antérieur différentes sortes de matrices de photodiodes, en particulier les matrices de photodiodes réalisées dans une couche en matériau semi-conducteur fait d'un alliage de cadmium, mercure et tellure $Cd_xHg_{1-x}Te$, avec x un réel compris entre 0 et 1, les bornes étant exclues. Dans tout le texte, cette couche en matériau semi-conducteur est nommée « couche utile ».

Ces photodiodes sont utilisées par exemple dans le domaine spatial, pour la détection du rayonnement infrarouge, notamment l'infrarouge moyen (ou MWIR pour l'anglais « Middle Wave InfraRed », correspondant à des longueurs d'onde comprises entre 4 $\mu$m et 5 $\mu$m à 80 K) et l'infrarouge lointain (ou LWIR pour l'anglais « Long Wave InfraRed », correspondant à des longueurs d'onde supérieures à 8 $\mu$m à 80 K).

En variante, ces photodiodes peuvent également être utilisées pour la détection du rayonnement infrarouge dit SWIR (pour « Small Wave Infrared », correspondant à des longueurs d'onde entre 2 et 3 $\mu$m à 80 K), et du rayonnement infrarouge dit VLWIR (pour « Very Long Wave Infrared», correspondant à des longueurs d'ondes supérieures à 14 $\mu$m à 80 K).

On réalise par exemple des matrices rectangulaires regroupant 640x512 photodiodes, pour un pas 15 $\mu$m (largeur d'une photodiode).

Une photodiode présente généralement un courant dit courant d'obscurité. Le courant d'obscurité est le courant électrique résiduel d'un photodétecteur en l'absence d'éclairement lumineux.

Une photodiode à structure mésa est une photodiode non-planaire, c'est-à-dire présentant des variations topologiques du côté supérieur de la couche utile, sur une face dite utile. On nomme « mésa » chaque partie émergente, entre les tranchées. La réalisation technologique d'une photodiode à structure mésa nécessite donc la création de tranchées dans la couche utile. En particulier, une matrice de photodiodes à structure mésa est réalisée à partir d'un empilement de deux couches dopées, l'interface entre les deux couches dopées formant une jonction PN. On grave ensuite des tranchées, nommées « sillons », dans l'empilement de couches dopées. Cette gravure permet de séparer des plots présentant chacun une jonction PN et correspondant chacun à une photodiode. Dans ce type de technologie, la gravure des tranchées peut induire la présence de défauts augmentant le courant d'obscurité. En particulier, la gravure de l'empilement de couches dopées crée des défauts de matériau aux interfaces gravées. Ces défauts de matériau entraînent des créations spontanées de paires électrons trous. Une paire électron-trou correspond à l'apparition dans la couche utile d'un porteur minoritaire (l'électron ou le trou). Lorsque le porteur minoritaire traverse la jonction PN, on mesure un courant électrique qui ne correspond pas à l'absorption d'un rayonnement électromagnétique. On parle pour cette raison de courant d'obscurité. Une augmentation du courant d'obscurité empêche, par exemple, de détecter de très faibles rayonnements dans l'infrarouge.

On connaît dans l'art antérieur le brevet US 5,880,510, qui décrit une matrice de photodiodes de type mésa, munie d'une couche de passivation à gradient de cadmium.

On connait également le document EP 2 752 893, qui décrit une matrice de photodiodes à avalanche dans laquelle une couche recevant les zones d'absorption des photodiodes comporte des éléments de séparation électrique.

Un objectif de la présente invention est de proposer une matrice de photodiodes $Cd_xHg_{1-x}Te$ réalisée à partir d'un empilement de couches dopées, et présentant un courant d'obscurité réduit.

Un autre but de la présente invention est de proposer un procédé de fabrication d'une telle matrice de photodiodes.

**EXPOSÉ DE L'INVENTION**

Cet objectif est atteint avec une matrice de photodiodes selon la revendication 1.

La matrice de photodiodes forme ainsi une matrice planaire, dans laquelle une jonction PN s'étend sur toute l'étendue de la couche utile.

Cette jonction PN est formée d'un seul tenant. En d'autres termes, chaque interface entre deux couches dopées superposées forme une unique jonction PN. Cette unique jonction PN est traversée par les régions de séparation qui dessinent plusieurs photodiodes, à partir de cette unique jonction PN. Ainsi, au moins deux photodiodes, ou pixels de la matrice, partagent la même jonction PN.

Avantageusement, la concentration moyenne en cadmium dans la région de séparation est supérieure à la concentration moyenne en cadmium dans le restant de la couche utile.

La couche utile peut consister en deux couches dopées présentant chacune un dopage de nature différente.

En variante, la couche utile peut consister en trois couches dopées formant ensemble deux jonctions PN, deux couches dopées présentant un dopage de même nature encadrant une couche dopée médiane présentant un dopage de nature différente, et la région de séparation traversant les deux jonctions PN.

La région de séparation présente un gradient de cadmium décroissant depuis la face supérieure de la couche utile et en direction de sa face inférieure.

La région de séparation peut être séparée de la face inférieure de la couche utile par au moins une portion de ladite couche utile.

Les volumes utiles sont avantageusement répartis dans la couche utile selon un maillage régulier.

En particulier, les volumes utiles peuvent être répartis dans la couche utile selon un maillage carré, et séparés les uns des autres par une unique région de séparation.

Selon un mode de réalisation avantageux, la matrice de photodiodes selon l'invention comprend au moins une zone sur-dopée, située dans une région formée par l'intersection entre une région de séparation et la couche dopée située du côté de la face supérieure de la couche utile, dite couche dopée supérieure, la zone sur-dopée présentant un dopage de type opposé à celui de ladite couche dopée supérieure.

L'invention concerne également un procédé de fabrication d'une telle matrice de photodiodes selon la revendication 10.

De préférence, les ouvertures traversantes sont réparties dans la couche structurée selon un maillage régulier.

Lesdites étapes de réalisation d'une couche structurée, et recuit, forment avantageusement un cycle de fabrication, et l'on met en oeuvre au moins deux cycles de fabrication.

Le recuit peut être réalisé à une température comprise entre 100°C et 500°C.

Le recuit peut être réalisé pendant une durée comprise entre 1h et 100h.

Le procédé selon l'invention peut comprendre une étape de dopage, de façon à réaliser au moins une zone sur-dopée, située dans une région formée par l'intersection entre une région de séparation et la couche dopée située du côté de la face supérieure de la couche utile, dite couche dopée supérieure, la zone sur-dopée présentant un dopage de type opposé à celui de ladite couche dopée supérieure.

**BRÈVE DESCRIPTION DES DESSINS**

La présente invention sera mieux comprise à la lecture de la description d'exemples de réalisation donnés à titre purement indicatif et nullement limitatif, en faisant référence aux dessins annexés sur lesquels :

- la figure 1 illustre de manière schématique un premier mode de réalisation de procédé selon l'invention ;
- la figure 2 illustre selon une vue en perspective un premier mode de réalisation d'une matrice de photodiodes selon l'invention ;
- la figure 3 illustre de manière schématique un deuxième mode de réalisation de procédé selon l'invention ;
- la figure 4 illustre selon une vue en perspective un deuxième mode de réalisation d'une matrice de photodiodes selon l'invention ; et
- la figure 5 illustre selon une vue en coupe un troisième mode de réalisation d'une matrice de photodiodes selon l'invention.

**EXPOSÉ DÉTAILLÉ DE MODES DE RÉALISATION PARTICULIERS**

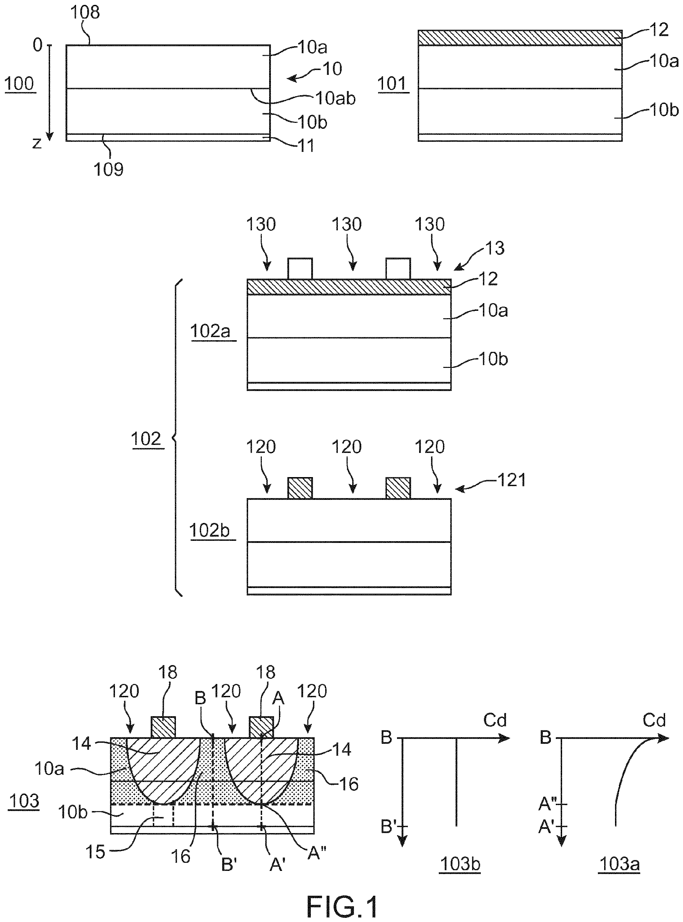

On a illustré en figure 1, et de façon schématique, les étapes d'un procédé selon l'invention de fabrication d'une matrice de photodiodes. Les vues de la figure 1 sont des vues en coupe.

Le procédé de la figure 1 met en oeuvre une couche utile 10 en matériau semi-conducteur fait d'un alliage de cadmium, mercure et tellure $Cd_xHg_{1-x}Te$, avec x un réel compris entre 0 et 1, les bornes étant exclues. En particulier, x est inférieur à 0,5. On a typiquement x compris entre 0,2 et 0,4. Dans l'exemple de la figure 1, la concentration en cadmium dans la couche utile 10 est constante dans l'espace.

Par exemple, on cherchera à détecter un rayonnement dans l'infrarouge moyen dit MWIR, ce qui correspond à une concentration en cadmium définie par x=0,3. En variante, on cherche à détecter un rayonnement dans l'infrarouge lointain dit LWIR, ce qui correspond à une concentration en cadmium définie par x=0,22.

On pourrait également vouloir détecter des longueurs d'onde dans le SWIR ou le VLWIR.

Cette couche utile 10 est réalisée sur un substrat 11, par exemple un substrat fait d'un alliage de cadmium, zinc, tellure. Un tel alliage offre un accord de maille très avantageux du matériau de la couche utile 10 avec le substrat 11. Le substrat 11 est transparent aux longueurs d'onde que l'on souhaite détecter. Selon une variante non représentée, le substrat est séparé de la couche utile avant, pendant ou après la mise en oeuvre du procédé selon l'invention. Ainsi, la matrice selon l'invention ne comprend pas nécessairement un substrat.

La couche utile 10 présente typiquement une épaisseur comprise entre 1 $\mu$m et 20 $\mu$m, par exemple 15 $\mu$m. Le substrat 11 présente une épaisseur de l'ordre de 500 $\mu$m. Pour des raisons de clarté des figures, l'épaisseur du substrat 11 est sous dimensionnée sur les figures.

La couche utile présente par exemple une forme de parallélépipède, notamment un parallélépipède rectangle. On définit dans cette couche utile un axe z partant de la face 108, reliant les faces 108 et 109, et définissant l'axe de la profondeur. La face 109 est une face inférieure (ici au contact du substrat 11). La face 108 est une face supérieure, du côté opposé à la face inférieure 109.

Etape 100 :

Au cours d'une première étape 100, on réalise une couche utile 10, présentant une jonction PN 10ab qui s'étend selon un plan, sur toute l'étendue de la couche utile 10. Il s'agit en particulier d'un plan orthogonal à l'axe z.

La jonction PN 10ab est formée ici par l'interface entre les deux couches dopées 10a et 10b superposées, présentant chacune un dopage N ou P de nature différente. Par exemple, la couche dopée 10a est dopée P, et la couche dopée 10b est dopée N. Les couches dopées 10a et 10b forment ensemble la couche utile 10, et s'étendent donc toutes les deux sur toute l'étendue de la couche utile. La couche 10a peut être dite couche dopée supérieure. La couche 10b peut être dite couche dopée inférieure.

Dans tout le texte, une couche est dite dopée P lorsqu'elle présente un excès de « trous », ou en d'autres termes un défaut d'électrons (porteurs minoritaires). Une couche est dite dopée N lorsqu'elle présente un excès d'électrons, ou en d'autres termes un défaut de trous (porteurs minoritaires). Dans tout le texte, la nature du dopage d'une couche dopée désigne la nature des porteurs majoritaires dans ladite couche. On parle également d'un type de dopage (N ou P).

Dans l'exemple illustré en figure 1, les couches dopées 10a et 10b sont formés lors de la croissance de la couche utile 10.

Par exemple, on dépose tout d'abord sur le substrat, une première couche qui contient des atomes dopants N tels que des atomes d'indium. On dépose ensuite sur cette première couche, une deuxième couche qui contient des atomes dopants P tels que des atomes d'arsenic. Ces deux couches forment la couche utile 10. On réalise ensuite un recuit à environ 400°C pour activer les dopants P. Ce recuit crée des lacunes de mercure dans toute la couche utile 10. On obtient donc une couche fortement dopée P (grâce aux atomes d'arsenic), au-dessus d'une couche faiblement dopée P (à cause des lacunes de mercure). On réalise ensuite un recuit à environ 220°C sous pression saturante de mercure pour combler les lacunes de mercure. On obtient ainsi une couche 10a fortement dopée P au-dessus d'une couche 10b dopée N.

Pour l'ensemble des recuits nécessaires, l'homme du métier saura procéder à des recuits dans des conditions de pression et température qui limitent la dégradation du matériau.

En variante, la couche dopée 10a est dopée N avec des atomes d'indium à la croissance, et la couche dopée 10b est dopée P. Pour cela, on dépose par exemple, sur le substrat, une première couche qui contient des atomes dopants d'arsenic. On dépose ensuite, sur la première couche, une deuxième couche qui contient des atomes dopants N tels que des atomes dopants d'indium. On réalise ensuite un recuit à environ 400°C pour activer les dopants P. Ce recuit crée des lacunes de mercure dans toute la couche utile 10. On obtient donc une couche fortement dopée P (grâce aux atomes d'arsenic), au-dessous d'une couche faiblement dopée P (à cause des lacunes de mercure). On réalise ensuite un recuit à environ 220°C sous pression saturante de mercure pour combler les lacunes de mercure. On obtient ainsi une couche 10a dopée N au-dessus d'une couche 10b dopée P.

Il est également possible d'effectuer le dopage P de la couche 10b par ses impuretés intrinsèques comme les lacunes de mercure. Pour cela la concentration en lacunes mercure doit être contrôlée par des recuits adaptés et ce recuit ne doit pas impacter le dopage de la couche N.

La densité de dopage (des atomes d'indium) dans la couche N est par exemple de $1.10^{16}$ atomes/cm$^3$, et la densité de dopage (des atomes d'arsenic) dans la couche P est égale ou supérieure à $10^{18}$ atomes/cm$^3$.

Les dépôts de couches formant ensuite les couches dopées 10a et 10b sont avantageusement réalisés par une technique dite d'épitaxie par jet moléculaire. L'épitaxie par jet moléculaire est une technique de croissance d'un cristal dans laquelle les éléments à déposer sur un support sont évaporés puis vont se déposer sur ce support. En variante, on pourra utiliser une technique d'épitaxie en phase liquide. L'épitaxie en phase liquide est une technique de croissance d'un cristal dans laquelle le support est mis en contact avec une phase liquide d'un élément souhaité qui se cristallise sur le support. On pourra également envisager toute autre technique de dépôt d'une couche cristalline sur un support, par exemple un dépôt chimique en phase vapeur.

Etape 101 :

Lors de l'étape 101, on dépose sur la face supérieure 108 de la couche utile 10 une couche dite couche de réservoir 12 dont l'un des éléments est du cadmium et présentant une concentration en cadmium supérieure à la concentration moyenne en cadmium de la couche utile 10.

La couche de réservoir 12 est réalisée en un matériau binaire, ternaire, ou quaternaire, voire plus. Ce matériau comprend avantageusement des éléments appartenant aux colonnes II et VI du tableau périodique des éléments. Il s'agit par exemple et de manière non limitative de CdS, CdSe, CdTe, CdZnSe, CdMnSSe, etc.

La couche de réservoir 12 présente une épaisseur de l'ordre du micromètre, par exemple entre 0,1 $\mu$m et 10 $\mu$m, en particulier 1 $\mu$m.

Le dépôt de la couche de réservoir 12 est effectué par toute technique connue de dépôt de couche mince.

La couche de réservoir 12 forme ainsi une couche uniforme qui recouvre toute la face supérieure 108 de la couche utile 10.

Etape 102 :

La couche de réservoir 12 est ensuite gravée de façon à y former des ouvertures traversantes 120. On nomme cette étape structuration, ou texturation de la couche de réservoir 12. La couche de réservoir après structuration forme une couche dite structurée 121. La couche structurée 121 présente donc la même concentration en cadmium que la couche de réservoir 12. On nomme « ouverture traversante » une ouverture traversant une couche de part en part, dans le sens de l'épaisseur.

La réalisation de la couche structurée 121 présente de préférence une étape de gravure physique ou chimique.

L'étape 102 se décompose par exemple en deux étapes 102a et 102b.

### Etape 102a :

Dans une première étape 102a, on dépose une couche de résine sur la couche de réservoir 12, puis on grave dans cette résine des ouvertures traversantes 130. Il s'agit préférentiellement d'une gravure par photolithographie. On forme ainsi un masque de résine 13, situé sur la couche de réservoir 12.

### Etape 102b :

Dans une deuxième étape 102b, on grave la couche de réservoir 12 à travers le masque de résine 13. Ainsi, on grave la couche de réservoir 12 uniquement aux emplacements non recouverts par la résine.

La gravure est avantageusement une gravure chimique, typiquement une gravure chimique à l'aide d'une solution de Brome. On ajuste la profondeur de gravure en ajustant une durée de la gravure chimique. En pratique, la couche de réservoir présente un aspect différent de la couche utile, c'est pourquoi on pourra repérer optiquement le moment à compter duquel on peut faire cesser la gravure chimique.

Toute autre méthode de structuration est également envisageable telle qu'une gravure chimique sélective entre la couche de réservoir 12 riche en cadmium, et la couche utile en alliage de cadmium, mercure, tellure. Une gravure non chimique sélective ou non chimique non-sélective est également envisageable à condition qu'elle ne crée pas de défauts additionnels dommageables dans la couche utile.

Les étapes suivantes :

- dépôt 101, sur la face supérieure 108 de la couche utile, d'une couche de réservoir 12 présentant une concentration en cadmium supérieure à la concentration moyenne en cadmium de la couche utile 10 ; et
- gravure 102 d'au moins une ouverture traversante 120 dans la couche de réservoir, formant ainsi une couche dite structurée 121 ;

forment ensemble une étape de réalisation, sur ladite face supérieure 108, d'une couche structurée 121 présentant au moins une ouverture traversante 120, et une concentration en cadmium supérieure à la concentration moyenne en cadmium dans la couche utile 10.

Il est également envisageable de réaliser la couche structurée 121 par une technologie « lift-off ». Il s'agit par exemple de déposer une couche structurée de résine sur la face supérieure 108, et de recouvrir le tout par la couche de réservoir 12. La couche de réservoir se dépose donc sur la résine, là où la résine est présente, et sur la couche utile 10 au niveau des ouvertures traversantes dans la résine. En retirant la résine, on obtient la couche structurée 121.

### Etape 103 :

On effectue ensuite un recuit adapté de l'ensemble formé par la couche utile 10 et la couche structurée 121. Ce recuit sera par exemple effectué à une température comprise entre 100°C et 500°C, de préférence entre 300°C et 500°C, et pendant une durée pouvant aller de quelques minutes à plusieurs heures, par exemple entre 1h et 100h, par exemple entre 1h et 40h. Dans l'exemple représenté en figure 1, le recuit correspond à un chauffage à 430° durant 50h.

La couche correspondant à la couche structurée 121 après recuit est nommée couche subsistante 18. On pourra prévoir de supprimer la couche subsistante 18. On pourra par exemple utiliser un procédé de planarisation.

Au cours de ce recuit, les atomes de cadmium de la couche structurée 121 vont diffuser vers la couche utile 10. On peut donc parler d'un recuit de diffusion. Ce recuit conserve la qualité de la structure cristalline de la couche utile.

Il se forme ainsi, sous les portions pleines de la couche structurée 121, des régions de séparation 14 présentant chacune un gradient de concentration en cadmium décroissant, depuis la face supérieure 108 vers la face inférieure 109 de la couche utile. Les portions pleines de la couche structurée 121 désignent les portions entourant les ouvertures traversantes, c'est-à-dire le cas échéant les portions de couche de réservoir 12 subsistant après l'étape 102.

Dans tout le texte, une concentration de cadmium constante dans l'espace ne définit pas un gradient de concentration.

Le gradient de concentration est notamment un gradient continu, sans rupture de pente brutale.

Les régions de séparation 14 séparent au moins deux volumes dits utiles 16, qui s'étendent dans la couche utile 10 aussi profondément que lesdites régions de séparation 14. Pour des raisons de lisibilité de la figure 1, les volumes utiles sont représentés par des surfaces en pointillés.

Les régions de séparation 14 s'étendent dans la couche utile 10 depuis la face supérieure 108 jusqu'à l'intérieur de la couche dopée inférieure 10b, c'est-à-dire jusqu'à l'intérieur de la couche dopée comprenant la face inférieure de la couche utile. Le cas échéant, cette couche dopée peut être définie comme étant la couche dopée la plus proche du substrat 11. Les régions de séparation 14 traversent donc la jonction PN 10ab, le cas échéant la jonction 10ab la plus proche de la face inférieure 109 de la couche utile. Ces régions de séparation 14 s'étendent par exemple sur au moins un tiers de l'épaisseur de la couche dopée inférieure 10b, de préférence au moins la moitié. De préférence, chaque région de séparation 14 est séparée de la face inférieure 109 de la couche utile par une portion 15 de la couche utile. Il est également possible qu'au moins une région de séparation 14 traverse l'intégralité des deux couches dopées 10a et 10b. Dans ce cadre, on optimise la fonction de transfert de modulation (FTM) des diodes, en plus des avantages qui seront détaillés dans la suite.

Puisque des atomes de cadmium ont diffusé dans les régions de séparation 14, la concentration moyenne en cadmium dans ces régions est supérieure à la concentration moyenne en cadmium dans au moins un volume utile 16 adjacent.

Pour la même raison, la concentration moyenne en cadmium dans ces régions 14 est supérieure à la concentration moyenne en cadmium dans le restant de la couche utile. En particulier, la concentration moyenne en cadmium dans les régions 14 est supérieure à la concentration moyenne en cadmium dans une région de la couche utile destinée à former une région d'absorption de la couche utile, dans laquelle les photons à la longueur d'onde que l'on souhaite détecter vont former des porteurs minoritaires.

On pourra également retenir le critère selon lequel, au-delà d'une profondeur prédéterminée (ici z=0) dans la couche utile 10, la concentration moyenne en cadmium dans les régions de séparation 14 est supérieure à la concentration moyenne en cadmium dans les volumes utiles 16. Sans précision, le terme « concentration » désigne une concentration volumique.

On pourra également utiliser le critère suivant, en considérant des surfaces dans la couche utile, parallèles à la face supérieure 108, et définies par une profondeur z dans la couche utile. Passé une profondeur prédéterminée dans la couche utile 10, l'intersection d'une telle surface avec les régions 14 présente une concentration surfacique moyenne en cadmium supérieure à la concentration surfacique moyenne en cadmium de l'intersection de cette même surface avec le reste de la couche utile. Dans l'exemple illustré en figure 1, ladite profondeur prédéterminée est inférieure à l'épaisseur de couche utile 10 depuis la face supérieure 108 jusqu'à la jonction PN 10ab. En particulier, ladite profondeur prédéterminée est définie par z=0.

Les régions 14 débouchent toutes sur la face supérieure 108.

On a représenté, à droite, des graphiques 103a et 103b représentant une concentration en cadmium Cd dans la couche utile (axe des abscisses) en fonction de la profondeur dans la couche utile (axe des ordonnées).

Le graphique 103b correspond à une coupe dans la couche utile selon l'axe BB' passant par un volume utile 16. On voit bien que la concentration en cadmium présente alors une valeur continue, et correspondant à la concentration initiale en cadmium de la couche utile.

Le graphique 103a correspond à une coupe dans la couche utile selon l'axe AA' passant dans une région de séparation 14. La concentration en cadmium présente un profil décroissant progressivement à partir de la face supérieure 108 et en direction de la face inférieure 109. Par exemple, ce gradient prend une valeur maximale définie par x=0,5 dans du $Cd_xHg_{1-x}Te$, et une valeur minimale définie par x=0,22 et correspondant à la concentration initiale en cadmium de la couche utile. Le gradient, et donc la région de séparation 14, s'étend dans la couche utile jusqu'en A''. Le point A'' se trouve environ à la moitié de l'épaisseur de la couche dopée 10b, par exemple à une distance de 1 $\mu$m de la face inférieure 109.

La diffusion des atomes, notamment les atomes de cadmium, peut être approximée par une loi de diffusion standard de type Fick :

$$n(z, t) = \frac{1}{\sqrt{\pi Dt}}\, e^{-\frac{z^2}{4Dt}},$$

avec

- n(z, t) la concentration volumique en atomes d'une espèce donnée en fonction de la profondeur z et du temps t ;
- t la durée du recuit ;
- D le coefficient de diffusion de l'atome, avec $D = D_0\, e^{-\frac{Ea}{kT}}$, T la température du recuit et Ea l'énergie d'activation de la diffusion (quantité d'énergie nécessaire pour lancer le processus de diffusion des atomes).

On vérifie en effet que le gradient de concentration en cadmium suit une courbe décroissante en partant de la face supérieure 108 (point A) et en direction de la face inférieure 109 (jusqu'au point A''), et présentant un profil sensiblement exponentiel. Les régions de séparation 14 débouchent toutes sur la face supérieure 108.

En fonction des caractéristiques souhaitées de la région de séparation 14, notamment sa profondeur et le profil du gradient de concentration, l'homme du métier saura adapter la température et la durée du recuit. Il pourra également jouer sur la forme de la couche structurée 121 (taille et forme des ouvertures traversantes, espacement entre les ouvertures traversantes), et son épaisseur.

On pourra prévoir plusieurs cycles comprenant chacun les étapes de réalisation d'une couche structurée 121, et recuit. Entre deux cycles, on supprime avantageusement la couche correspondant, après recuit, à la couche structurée précédemment formée. Chacun des cycles peut mettre en oeuvre une couche structurée de forme différente.

Dans l'exemple représenté en figure 1, on réalise la jonction PN 10ab avant l'étape de recuit 103.

En variante, on peut prévoir de réaliser la jonction PN 10ab après l'étape de recuit 103. Par exemple, la couche dopée supérieure 10a est alors dopée N avec des atomes d'indium. Les atomes d'indium sont activés à la croissance, et dopent la couche 10a selon un dopage de type N.

Selon une autre variante, un unique recuit réalise à la fois la diffusion du cadmium, et l'activation d'un dopant P. Dans ce cas, on peut par exemple réaliser à la croissance une couche supérieure 10a comprenant des éléments dopants P encore non activés. Ces éléments dopants P seront activés en même temps que le cadmium diffusera depuis la couche structurée vers la couche active.

On pourra ensuite réaliser des étapes classiques d'installation d'éléments de contact électrique au contact de la couche utile. Ces éléments de contact électrique permettent de polariser électriquement les photodiodes. On prévoit par exemple un contact pour chaque photodiode, relié électriquement à la couche dopée supérieure 10a, et un contact commun à toutes les photodiodes relié électriquement à la couche dopée inférieure 10b.

On a observé que dans un matériau semi-conducteur en $Cd_xHg_{1-x}Te$, la bande interdite, nommée « gap », dépend de la concentration en cadmium. Plus cette concentration est élevée, plus le gap est élevé. On comprend ainsi que les régions de séparation 14 forment avec les volumes utiles 16 une hétérostructure 3D noncontinue.

La différence de niveaux d'énergie dans une région de séparation 14 et dans un volume utile 16 forme une barrière de potentiel. Ainsi, chaque région de séparation 14, grâce à une forte concentration en cadmium, forme une barrière de potentiel en profondeur entre deux volumes utiles 16 voisins.

Cette barrière de potentiel enferme des porteurs minoritaires dans un volume utile 16 de la couche utile. Chacun des volumes utiles 16 comprend une portion de la jonction PN 10ab entre les couches dopées 10a et 10b, de sorte que chaque volume utile 16 correspond à une photodiode.

Selon l'art antérieur, partant d'un empilement de couches dopées et souhaitant réaliser une matrice de photodiodes, on séparait des plots comprenant chacun une jonction PN, par gravure de tranchées dans l'empilement. L'idée à la base de l'invention est de séparer des plots comprenant chacun une jonction PN en plaçant des barrières de potentiel entre ces plots. On évite ainsi toute étape de gravure pour séparer des plots. On s'affranchit ainsi des inconvénients liés à la gravure. Par ailleurs, on reste sur une technologie dite planaire, c'est-à-dire telle que la couche utile présente une face supérieure sensiblement planaire. En d'autres termes, la couche utile ne présente pas de forte variation de la topographie de sa face supérieure. La technologie planaire simplifie des étapes ultérieures, dites de «packaging des composants » (par exemple installation des éléments de contact électrique). On peut parler de pixellisation de la couche utile 10.

Comme précisé en introduction, la gravure de séparation des plots est à l'origine d'un courant d'obscurité dans la photodiode, dont l'invention permet donc de s'affranchir.

L'invention permet en outre de s'affranchir des inconvénients inhérents à la géométrie mésa, et notamment des autres défauts liés à la gravure des structures mésa :

- des porteurs minoritaires créés dans la couche utile en réaction à l'absorption d'un photon, peuvent avoir tendance à se recombiner au niveau des défauts de matériau de l'interface gravée, et non après traversée d'une jonction PN. Dans ce cas, un photon incident dans la couche utile, et à la longueur d'onde de détection, provoquera bien l'apparition d'un porteur minoritaire, mais pas celle d'un courant mesurable dans une photodiode mésa. Les propriétés optiques de la matrice de photodiodes mésa sont donc dégradées ;

- inversement, la présence de défauts liés à la gravure du mésa peut induire la création de porteurs minoritaires. Par exemple, la présence de défauts dans la zone de charge d'espace (ZCE) d'une photodiode va entraîner la création de porteurs minoritaires par un phénomène de génération-recombinaison dans la ZCE. Ces porteurs vont être à l'origine d'un courant électrique en l'absence de flux photonique. Ces défauts vont donc augmenter le courant d'obscurité de la photodiode et ainsi dégrader les performances de la matrice de photodiodes. D'autres phénomènes que la génération-recombinaison, liés à ces défauts, peuvent être à l'origine d'une augmentation du courant d'obscurité.

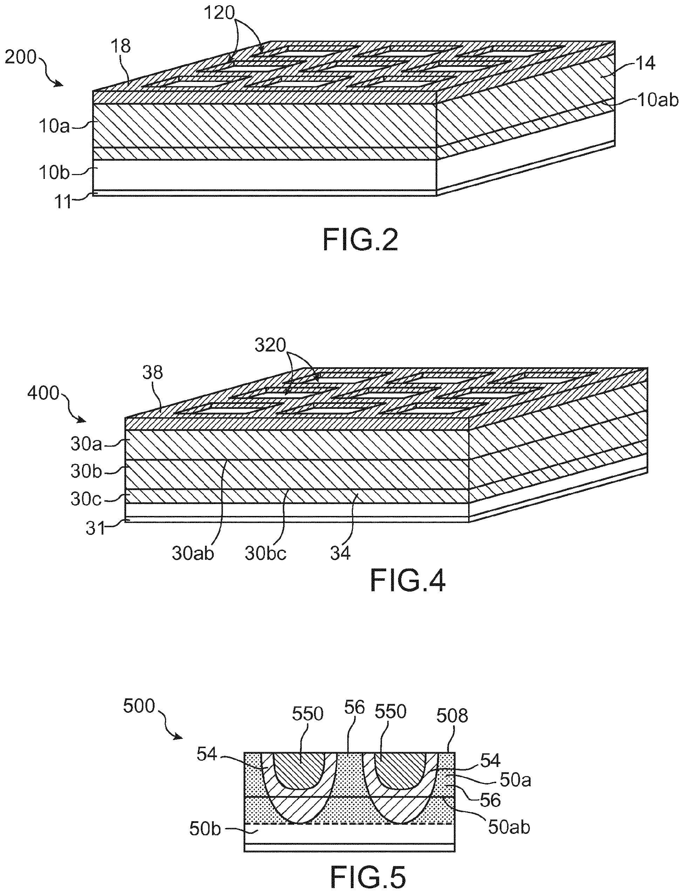

La figure 2 est une vue en perspective d'une matrice de photodiodes 200 obtenue à l'aide du procédé de la figure 1. La matrice de photodiodes 200 présente une géométrie planaire.

Dans l'exemple représenté en figure 2, une unique région de séparation 14 formée d'un seul tenant permet d'isoler tous les volumes utiles (non représentés en figure 2). Les ouvertures 120 dans la couche subsistantes 18, et donc les volumes utiles, sont répartis dans la couche utile selon un maillage régulier, notamment un maillage carré. On parle de maillage régulier lorsque tous les motifs présentent la même forme et sont régulièrement espacés dans l'espace.

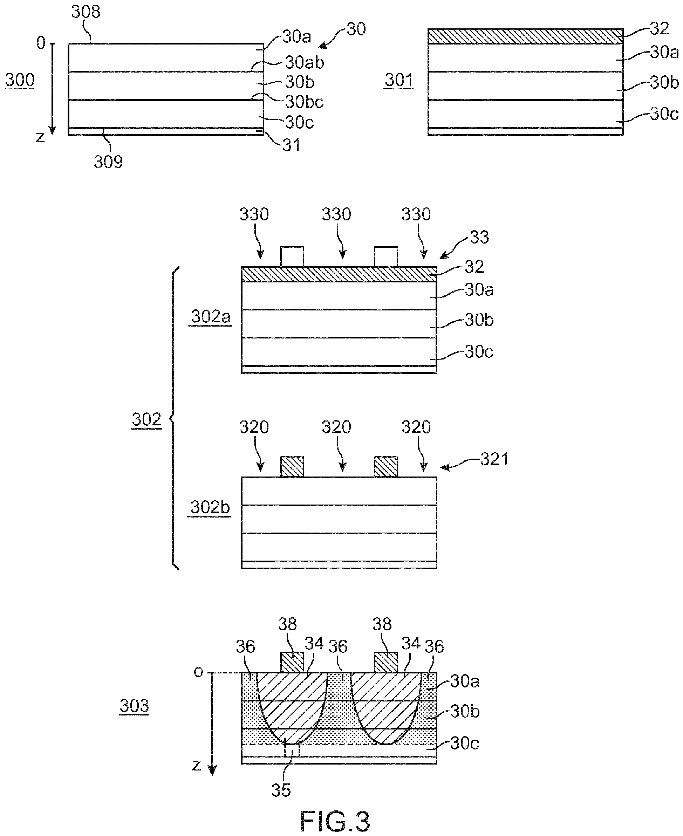

La figure 3 illustre un deuxième mode de réalisation de procédé selon l'invention. Les références numériques de la figure 3 correspondent aux références numériques de la figure 1, le premier chiffre de chaque nombre étant remplacé par un 3.

La figure 3 ne sera décrite que pour ses différences au regard de la figure 1.

La couche utile 30 réalisée à l'étape 301 consiste en un empilement de trois couches dopées 30a, 30b et 30c, formant ensemble la couche utile 30. Les couches dopées 30a et 30c présentent chacune un dopage N ou P, de nature différente de celui de la couche 30b. L'interface 30ab entre les couches dopées 30a et 30b forme donc une première jonction PN. L'interface 30bc entre les couches dopées 30b et 30c forme une deuxième jonction PN.

La couche de réservoir 32 présente une concentration en cadmium supérieure à la concentration moyenne en cadmium dans la couche utile 30, la couche utile 30 étant formée par les trois couches dopées 30a, 30b, 30c.

A l'issu du recuit de diffusion 303, il se forme des régions de séparation 34 dans lesquelles des atomes de cadmium ont diffusé.

Selon une première variante du mode de réalisation représenté en figure 3, au-delà d'une profondeur prédéterminée dans la couche utile 10 correspondant à la profondeur de la jonction PN 30bc, la concentration moyenne en cadmium dans les régions de séparation 34 est supérieure à la concentration moyenne en cadmium dans les volumes utiles 36.

Selon une deuxième variante du mode de réalisation représenté en figure 3, la concentration moyenne en cadmium dans les régions de séparation 34 est supérieure à la concentration moyenne en cadmium dans les volumes utiles 36.

Les régions de séparation 34 s'étendent jusqu'à l'intérieur de la couche dopée 30c, en traversant les deux jonctions PN 30ab et 30bc. En particulier, les régions de séparation 34 traversent la jonction PN 30 bc, qui est la jonction PN la plus proche de la face inférieure 309 de la couche utile 30. La couche dopée 30c de la figure 3 correspond à la couche dopée 10b de la figure 1.

La figure 4 est une vue en perspective d'une matrice de photodiodes 400 obtenue à l'aide du procédé de la figure 3. Elle correspond à la matrice 200 illustrée en figure 2, excepté qu'elle présente trois couches dopées au lieu de deux. La couche dopée supérieure 30a présente une épaisseur de l'ordre de 5 $\mu$m et un dopage N présentant une densité de dopage de l'ordre de $10^{17}$ atomes/cm$^3$. La couche dopée médiane 30b présente une épaisseur de l'ordre de 5 $\mu$m et un dopage P présentant une densité de dopage de l'ordre de $10^{17}$ atomes/cm$^3$. La couche dopée inférieure 30c présente une épaisseur de l'ordre de 10 $\mu$m et un dopage N présentant une densité de dopage de l'ordre de $10^{19}$ atomes/cm$^3$.

Un avantage d'une telle matrice de photodiodes à trois couches dopées est qu'elle forme un empilement de deux matrices élémentaire de photodiodes élémentaires positionnées tête bêche et partageant une même couche dopée médiane 30b. On a donc une série d'empilements de deux photodiodes positionnées tête bêche, chaque empilement de deux photodiodes correspondant à un empilement de deux jonctions PN positionnées tête bêche.

En polarisant l'une ou l'autre des jonctions PN 30ab ou 30bc, on utilise l'une ou l'autre matrice élémentaire de photodiodes. Avantageusement, une couche dopée supérieure 30a présente une première concentration en cadmium, qui correspond à l'absorption d'une première longueur d'onde, et une couche dopée inférieure 30c présente une deuxième concentration de cadmium, qui correspond à l'absorption d'une deuxième longueur d'onde.

La polarisation des jonctions PN se fait typiquement à l'aide :

- pour chaque empilement de deux photodiodes, d'un élément de contact électrique relié électriquement à la couche dopée supérieure 30a ; et
- d'un élément de contact électrique commun à tous les empilements de deux photodiodes, relié électriquement à la couche dopée inférieure 30c.

En polarisant en inverse la jonction PN entre la couche dopée supérieure 30a et la couche dopée médiane 30b, on détecte les photons incidents à la première longueur d'onde. En polarisant en inverse la jonction PN entre la couche dopée inférieure 30c et la couche dopée médiane 30b, on détecte les photons incidents à la deuxième longueur d'onde. Une même structure permet de détecter deux longueurs d'ondes différentes, c'est pourquoi on la nomme « matrice de photodiodes bispectrales ».

Typiquement, la couche dopée inférieure 30c présente une concentration en cadmium définie par x=0,3 (détection dans le MWIR), et la couche dopée supérieure 30a présente une concentration en cadmium définie par x=0,22 (détection dans le LWIR). La couche dopée médiane 30b peut présenter une concentration en cadmium définie par x=0,7 (correspondant à la détection d'un rayonnement dans le faible infrarouge, vers une longueur d'onde de 1,5 $\mu$m). L'ordre de l'empilement des couches est fonction de leur gap. On prévoit de préférence le gap le plus élevé encadré entre deux couches de gaps moindres.

On a illustré en figure 5 un troisième mode de réalisation d'une matrice de photodiodes 500 selon l'invention. Les références numériques de la figure 5 correspondent aux références numériques de la figure 1, le premier chiffre étant remplacé par un 5.

La matrice de photodiodes 500 selon l'invention est obtenue par la mise en oeuvre des étapes du procédé tel que décrit en référence à la figure 1, suivies des étapes suivantes :

- suppression de la couche structurée 521 ;
- sur-dopage local de façon à former au moins une zone sur-dopée 550 dans la couche utile, située à la fois à l'intérieur d'au moins une région de séparation 54 et à l'intérieur de la couche dopée supérieure 50a de la couche utile.

Chaque zone sur-dopée 550 est réalisée de façon à être située uniquement à l'intérieur d'au moins une région de séparation 54, c'est-à-dire dans une région de la couche utile où les atomes de cadmium ont diffusé.

La couche dopée supérieure 50a désigne l'une des couches dopées superposées formant ensemble la couche utile. La couche dopée supérieure 50a désigne plus particulièrement la couche dopée comprenant la face supérieure 508 de la couche utile. Chaque zone sur-dopée 550 est réalisée de façon à être située uniquement à l'intérieur de cette couche dopée supérieure 50a.

Ainsi, chaque zone sur-dopée 550 est réalisée de façon à être située à l'intérieur d'une région formée par l'intersection entre la couche dopée supérieure 50a et une région de séparation 54.

Une zone sur-dopée 550 peut s'étendre sur toute une région formée par l'intersection entre la couche dopée supérieure 50a et une région de séparation 54. En variante, une zone sur-dopée 550 peut s'étendre sur seulement une partie de la région formée par l'intersection entre la couche dopée supérieure 50a et une région de séparation 54.

Chaque zone sur-dopée 550 présente un dopage de nature différente de celle du dopage de la couche dopée supérieure 50a. Par exemple, soit une couche dopée supérieure dopée N, la zone sur-dopée 550 présente un dopage de type P. Inversement, soit une couche dopée supérieure dopée P, la zone sur-dopée 550 présente un dopage de type N. Chaque zone sur-dopée 550 présente de préférence un niveau de dopage au moins dix fois supérieur à celui de la couche dopée supérieure 50a.

Dans le cas où la couche dopée supérieure est dopée N, on peut réaliser une zone sur-dopée 550 par diffusion ou implantation d'atomes dopants P tels que des atomes d'arsenic ou de phosphore. Si nécessaire, on effectue ensuite un recuit d'activation.

Dans le cas où la couche dopée supérieure est dopée P, on peut réaliser une zone sur-dopée 550 par diffusion ou implantation d'atomes dopants N tels que des atomes de bore ou d'indium. Si nécessaire, on effectue ensuite un recuit d'activation.

On réalise ainsi une matrice de photodiodes 500, qui forme une variante avantageuse de la matrice de photodiodes telle qu'illustrée en figure 2.

L'au moins une zone sur-dopée 550 permet d'augmenter localement la valeur de bande interdite dans la couche utile, au voisinage des régions de séparation. On renforce ainsi la barrière de potentiel formée par les régions de séparation 54.

La matrice de photodiodes ainsi obtenue présente donc un courant d'obscurité encore réduit. Elle présente également une FTM encore améliorée.

On pourra réaliser de la même façon une variante du deuxième mode de réalisation d'un procédé et d'une matrice de photodiodes, illustrés en figures 3 et 4.

La couche utile peut présenter, avant réalisation d'une couche structurée, une concentration en cadmium plus élevée sur une certaine épaisseur du côté de sa face supérieure. Les régions de séparation peuvent présenter un dopage particulier.

**Revendications**

1. Matrice de photodiodes (200 ; 400 ; 500) planaire comprenant une couche utile (10 ; 30) en un alliage semi-conducteur de cadmium, mercure et tellure de type Cd$_x$Hg$_{1-x}$Te, la couche utile présentant une face inférieure (109 ; 309) et une face supérieure (108 ; 308 ; 508) du côté opposé à la face inférieure ;

   - la couche utile (10 ; 30) comprenant au moins deux couches dopées superposées (10a, 10b ; 30a, 30b, 30c ; 50a, 50b), chaque interface entre deux couches dopées adjacentes formant une jonction PN (10ab ; 30ab, 30bc ; 50ab) ;
   - la couche utile (10 ; 30) présentant au moins une région (14 ; 34 ; 54) dite de séparation, s'étendant depuis la face supérieure (108 ; 308 ; 508) de la couche utile vers sa face inférieure (109 ; 309) en traversant ladite jonction PN (10ab ; 30ab, 30bc ; 50ab) ;
   - la région de séparation (14 ; 34 ; 54) séparant au moins deux volumes (16 ; 36 ; 56) dits utiles et présentant un gradient de cadmium décroissant depuis la face supérieure (108 ; 308 ; 508) de la couche utile et en direction de sa face inférieure (109 ; 309) ; et
   - au-delà d'une profondeur prédéterminée dans la couche utile, la concentration moyenne en cadmium dans la région de séparation (14 ; 34 ; 54) étant supérieure à la concentration moyenne en cadmium dans les volumes utiles (16 ; 36 ; 56),

   **caractérisée en ce que** la jonction PN s'étend sur toute l'étendue de la couche utile et les volumes utiles s'étendent dans la couche utile aussi profondément que la région de séparation.

2. Matrice de photodiodes (200 ; 400 ; 500) selon la revendication 1, **caractérisée en ce qu'**au-delà d'une profondeur prédéterminée dans la couche utile (10, 30), la concentration surfacique moyenne en cadmium dans la région de séparation (14 ; 34 ; 54) est supérieure à la concentration surfacique moyenne en cadmium dans le reste de la couche utile (10 ; 30), sur des surfaces parallèles à la face supérieure (108) de la couche utile (10 ; 30).

**3.** Matrice de photodiodes (200 ; 400 ; 500) selon la revendication 1 ou 2, **caractérisée en ce que** la concentration moyenne en cadmium dans la région de séparation (14 ; 34 ; 54) est supérieure à la concentration moyenne en cadmium dans le restant de la couche utile.

**4.** Matrice de photodiodes (200 ; 500) selon l'une quelconque des revendications 1 à 3, **caractérisée en ce que** la couche utile (10) consiste en deux couches dopées (10a, 10b ; 50a, 50b) présentant chacune un dopage de nature différente.

**5.** Matrice de photodiodes (400) selon l'une quelconque des revendications 1 à 3, **caractérisée en ce que** la couche utile (30) consiste en trois couches dopées (30a, 30b, 30c) formant ensemble deux jonctions PN (30ab ; 30bc), deux couches dopées (30a, 30c) présentant un dopage de même nature encadrant une couche dopée médiane (30b) présentant un dopage de nature différente, et la région de séparation (34) traversant les deux jonctions PN (30ab ; 30bc).

**6.** Matrice de photodiodes (200 ; 400 ; 500) selon l'une quelconque des revendications 1 à 5, **caractérisée en ce que** la région de séparation (14; 34; 54) est séparée de la face inférieure (109 ; 309) de la couche utile par au moins une portion (15 ; 35) de ladite couche utile.

**7.** Matrice de photodiodes (200 ; 400 ; 500) selon l'une quelconque des revendications 1 à 6, **caractérisée en ce que** les volumes utiles (16 ; 36 ; 56) sont répartis dans la couche utile (10 ; 30) selon un maillage régulier.

**8.** Matrice de photodiodes (200 ; 400 ; 500) selon la revendication 7, **caractérisée en ce que** les volumes utiles (16 ; 36 ; 56) sont répartis dans la couche utile (10 ; 30) selon un maillage carré, et séparés les uns des autres par une unique région de séparation (14 ; 34 ; 54).

**9.** Matrice de photodiodes (500) selon l'une quelconque des revendications 1 à 8, **caractérisée en ce qu'**elle comprend au moins une zone sur-dopée (550), située dans une région formée par l'intersection entre une région de séparation (54) et la couche dopée située du côté de la face supérieure de la couche utile, dite couche dopée supérieure (50a), la zone sur-dopée présentant un dopage de type opposé à celui de ladite couche dopée supérieure (50a).

**10.** Procédé de fabrication d'une matrice de photodiodes planaire (200 ; 400 ; 500) selon l'une quelconque des revendications 1 à 9, le procédé comprenant les étapes suivantes :

- réalisation (100 ; 300) d'une couche utile (10 ; 30) en un alliage semi-conducteur de cadmium, mercure et tellure de type $Cd_xHg_{1-x}Te$, comprenant au moins une jonction PN (10ab ; 30ab, 30bc ; 50ab), située entre deux couches dopées superposées (10a, 10b ; 30a, 30b, 30c ; 50a, 50b) de la couche utile et qui s'étend sur toute l'étendue de la couche utile ;
- réalisation (101, 102 ; 301, 302), sur la face supérieure (108 ; 308 ; 508) de la couche utile (10 ; 30), d'une couche dite couche structurée (121 ; 321) présentant au moins une ouverture traversante (120 ; 320), et ayant une concentration en cadmium supérieure à la concentration moyenne en cadmium de la couche utile (10 ; 30) ;
- recuit (103 ; 303) de la couche utile (10 ; 30) recouverte de la couche structurée (121; 321), réalisant une diffusion des atomes de cadmium de la couche structurée (121 ; 321), depuis la couche structurée (121 ; 321) vers la couche utile (10 ; 30), formant ainsi l'au moins une région de séparation (14 ; 34 ; 54).

**11.** Procédé selon la revendication 10, **caractérisé en ce que** les ouvertures traversantes (120 ; 320) sont réparties dans la couche structurée (121 ; 321) selon un maillage régulier.

**12.** Procédé selon la revendication 10 ou 11, **caractérisé en ce que** lesdites étapes de réalisation (101, 102 ; 301, 302) d'une couche structurée (121 ; 321), et recuit (103 ; 303), forment un cycle de fabrication, et **en ce que** l'on met en oeuvre au moins deux cycles de fabrication.

**13.** Procédé selon l'une quelconque des revendications 10 à 12, **caractérisé en ce que** le recuit (103 ; 303) est réalisé à une température comprise entre 100°C et 500°C.

**14.** Procédé selon la revendication 13, **caractérisé en ce que** le recuit (103 ; 303) est réalisé pendant une durée comprise entre 1h et 100h.

**15.** Procédé selon l'une quelconque des revendications 10 à 14, **caractérisé en ce qu'**il comprend une étape de dopage, de façon à réaliser au moins une zone sur-dopée, située dans une région formée par l'intersection entre une région de séparation et la couche dopée située du côté de la face supérieure de la couche utile, dite couche dopée supérieure, la zone sur-dopée présentant un dopage de type opposé à celui de ladite couche dopée supérieure.

**Patentansprüche**

1. Planare Photodiodenmatrix (200; 400; 500), enthaltend eine Nutzschicht (10; 30) aus einer Halbleiterlegierung aus Cadmium, Quecksilber und Tellur vom Typ $Cd_xHg_{1-x}Te$, wobei die Nutzschicht eine Unterseite (109; 309) und eine Oberseite (108; 308; 508) auf der der Unterseite entgegengesetzten Seite aufweist;

   - wobei die Nutzschicht (10; 30) zumindest zwei übereinander angeordnete dotierte Schichten (10a, 10b; 30a, 30b, 30c; 50a, 50b) enthält, wobei jede Grenzfläche zwischen zwei benachbarten dotierten Schichten einen PN-Übergang (10ab; 30ab, 30bc; 50ab) bildet;
   - wobei die Nutzschicht (10; 30) zumindest einen sogenannten Trennbereich (14; 34; 54) aufweist, der sich von der Oberseite (108; 308; 508) der Nutzschicht zu ihrer Unterseite (109; 309) erstreckt, indem der durch den PN-Übergang (10ab; 30ab, 30bc; 50ab) tritt;
   - wobei der Trennbereich (14; 34, 54) zumindest zwei sogenannte Nutzvolumina (16; 36; 56) trennt und einen Cadmiumgradienten aufweist, der von der Oberseite (108; 308; 508) der Nutzschicht in Richtung zu ihrer Unterseite (109; 309) hin abnimmt; und
   - wobei jenseits einer vorbestimmten Tiefe in der Nutzschicht die durchschnittliche Cadmiumkonzentration im Trennbereich (14; 34; 54) größer als die durchschnittliche Cadmiumkonzentration in den Nutzvolumina (16; 36; 56) ist,

   **dadurch gekennzeichnet, dass** der PN-Übergang sich über die gesamte Erstreckung der Nutzschicht erstreckt und die Nutzvolumina sich in der Nutzschicht ebenso tief wie der Trennbereich erstrecken.

2. Photodiodenmatrix (200; 400; 500) nach Anspruch 1, **dadurch gekennzeichnet, dass** jenseits einer vorbestimmten Tiefe in der Nutzschicht (10, 30) die durchschnittliche Cadmiumoberflächenkonzentration im Trennbereich (14; 34; 54) größer als die durchschnittliche Cadmiumoberflächenkonzentration in der restlichen Nutzschicht (10; 30) an parallel zur Oberseite (108) der Nutzschicht (10; 30) verlaufenden Flächen ist.

3. Photodiodenmatrix (200; 400; 500) nach Anspruch 1 oder 2, **dadurch gekennzeichnet, dass** die durchschnittliche Cadmiumkonzentration im Trennbereich (14; 34; 54) größer als die durchschnittliche Cadmiumkonzentration in der restlichen Nutzschicht ist.

4. Photodiodenmatrix (200; 500) nach einem der Ansprüche 1 bis 3, **dadurch gekennzeichnet, dass** die Nutzschicht (10) aus zwei dotierten Schichten (10a, 10b; 50a, 50b) besteht, die jeweils eine Dotierung unterschiedlicher Beschaffenheit aufweisen.

5. Photodiodenmatrix (400) nach einem der Ansprüche 1 bis 3, **dadurch gekennzeichnet, dass** die Nutzschicht (30) aus drei dotierten Schichten (30a, 30b, 30c) besteht, die zusammen zwei PN-Übergänge (30ab; 30bc) bilden, wobei zwei dotierte Schichten (30a, 30c) eine Dotierung gleicher Beschaffenheit aufweisen, die eine dotierte Mittelschicht (30b) umschließen, welche eine Dotierung unterschiedlicher Beschaffenheit aufweist, wobei der Trennbereich (34) durch die beiden PN-Übergänge (30ab; 30bc) tritt.

6. Photodiodenmatrix (200; 400; 500) nach einem der Ansprüche 1 bis 5, **dadurch gekennzeichnet, dass** der Trennbereich (14; 34; 54) durch zumindest einen Abschnitt (15; 35) der Nutzschicht von der Unterseite (109; 309) der Nutzschicht getrennt ist.

7. Photodiodenmatrix (200; 400; 500) nach einem der Ansprüche 1 bis 6, **dadurch gekennzeichnet, dass** die Nutzvolumina (16; 36; 56) nach einem gleichmäßigen Muster in der Nutzschicht (10; 30) verteilt sind.

8. Photodiodenmatrix (200; 400; 500) nach Anspruch 7, **dadurch gekennzeichnet, dass** die Nutzvolumina (16; 36; 56) nach einem quadratischen Muster in der Nutzschicht (10; 30) verteilt sind und durch einen einzigen Trennbereich (14; 34; 54) voneinander getrennt sind.

9. Photodiodenmatrix (500) nach einem der Ansprüche 1 bis 8, **dadurch gekennzeichnet, dass** sie zumindest eine überdotierte Zone (550) enthält, die in einem Bereich liegt, der durch den Kreuzungsbereich zwischen einem Trennbereich (54) und der dotierten Schicht gebildet ist, welche dotierten Schicht auf der Seite der Oberseite der Nutzschicht liegt und dotierte Oberschicht (50a) genannt wird, wobei die überdotierte Zone eine Dotierung vom entgegengesetzten Typ zu der der dotierten Oberschicht (50a) aufweist.

10. Verfahren zum Herstellen einer planaren Photodiodenmatrix (200; 400; 500) nach einem der Ansprüche 1 bis 9, wobei das Verfahren die nachstehenden Schritte umfasst:

    - Herstellen (100; 300) einer Nutzschicht (10;

30) aus einer Halbleiterlegierung aus Cadmium, Quecksilber und Tellur vom Typ $Cd_xHg_{1-x}Te$, enthaltend zumindest einen PN-Übergang (10ab; 30ab, 30bc; 50ab), der zwischen zwei übereinander angeordneten dotierten Schichten (10a, 10b; 30a, 30b, 30c; 50a, 50b) der Nutzschicht liegt und sich über die gesamte Erstreckung der Nutzschicht erstreckt;
- Herstellen (101, 102; 301, 302) einer Schicht, strukturierte Schicht (121; 321) genannt, auf der Oberseite (108; 308; 508) der Nutzschicht (10; 30), welche strukturierte Schicht zumindest eine Durchgangsöffnung (120; 320) enthält und eine Cadmiumkonzentration hat, die höher als die durchschnittliche Cadmiumkonzentration der Nutzschicht (10; 30) ist;
- Tempern (103; 303) der mit der strukturierten Schicht (121; 321) überzogenen Nutzschicht (10; 30), wodurch eine Diffusion von Cadmiumatomen der strukturierten Schicht (121; 321) erfolgt, ausgehend von der strukturierten Schicht (121; 321) zur Nutzschicht (10; 30) hin, wodurch somit der zumindest eine Trennbereich (14; 34; 54) gebildet wird.

**11.** Verfahren nach Anspruch 10, **dadurch gekennzeichnet, dass** die Durchgangsöffnungen (120; 320) nach einem gleichmäßigen Muster in der strukturierten Schicht (121; 321) verteilt sind.

**12.** Verfahren nach Anspruch 10 oder 11, **dadurch gekennzeichnet, dass** die Schritte des Herstellens (101, 102; 301, 302) einer strukturierten Schicht (121; 321) und des Temperns (103; 303) einen Herstellungszyklus bilden und dass zumindest zwei Herstellungszyklen erfolgen.

**13.** Verfahren nach einem der Ansprüche 10 bis 12, **dadurch gekennzeichnet, dass** das Tempern (103; 303) bei einer Temperatur zwischen 100°C und 500°C erfolgt.

**14.** Verfahren nach Anspruch 13, **dadurch gekennzeichnet, dass** das Tempern (103; 303) für eine Dauer zwischen 1 Stunde und 100 Stunden erfolgt.

**15.** Verfahren nach einem der Ansprüche 10 bis 14, **dadurch gekennzeichnet, dass** es einen Schritt des Dotierens umfasst, so dass zumindest eine überdotierte Zone erzeugt wird, die in einem Bereich liegt, der durch den Kreuzungsbereich zwischen einem Trennbereich und der dotierten Schicht gebildet wird, welche dotierten Schicht auf der Seite der Oberseite der Nutzschicht liegt und dotierte Oberschicht genannt wird, wobei die überdotierte Zone eine Dotierung vom entgegengesetzten Typ zu der der dotierten Oberschicht aufweist.

**Claims**

**1.** Planar photodiode array (200 ; 400 ; 500) comprising a useful layer (10 ; 30) made of a cadmium, mercury and tellurium semi-conductor alloy of $Cd_xHg_{1-x}Te$ type, the useful layer having a lower face (109; 309) and an upper face (108 ; 308 ; 508) on the side opposite to the lower face;

- the useful layer (10; 30) comprising at least two superimposed doped layers (10a, 10b ; 30a, 30b, 30c; 50a, 50b), each interface between two adjacent doped layers forming a PN junction (10ab ; 30ab, 30bc; 50ab) ;
- the useful layer (10; 30) having at least one region (14 ; 34 ; 54) designated separation region, extending from the upper face (108 ; 308 ; 508) of the useful layer to its lower face (109 ; 309) while going through said PN junction (10ab ; 30ab, 30bc; 50ab);
- the separation region (14 ; 34; 54) separating at least two volumes, designated useful volumes (16 ; 36 ; 56) and having a cadmium gradient decreasing from the upper face (108; 308; 508) of the useful layer and in the direction of its lower face (109; 309); and
- beyond a predetermined depth in the useful layer, the average cadmium concentration in the separation region (14 ; 34; 54) being greater than the average cadmium concentration in the useful volumes (16 ; 36 ; 56);

**characterized in that** the PN junction extends over the whole extent of the useful layer and the useful volumes extend into the useful layer as deeply as the separation region

**2.** Photodiode array (200 ; 400 ; 500) according to claim 1, **characterised in that** beyond a predetermined depth in the useful layer (10; 30), the average surface cadmium concentration in the separation region (14 ; 34) is greater than the average surface cadmium concentration in the remainder of the useful layer (10; 30), over surfaces which are parallel to the upper face (108) of the useful layer (10; 30).

**3.** Photodiode array (200 ; 400 ; 500) according to claim 1 or 2, **characterised in that** the average cadmium concentration in the separation region (14 ; 34 ; 54) is greater than the average cadmium concentration in the remainder of the useful layer.

**4.** Photodiode array (200 ; 500) according to any of claims 1 to 3, **characterised in that** the useful layer (10) consists of two doped layers (10a, 10b ; 50a, 50b) each having a doping of different nature.

**5.** Photodiode array (400) according to any of claims 1 to 3, **characterised in that** the useful layer (30) consists of three doped layers (30a, 30b, 30c) forming together two PN junctions (30ab ; 30bc), two doped layers (30a, 30c) having a doping of same nature flanking a median doped layer (30b) having a doping of different nature, and the separation region (34) passing through the two PN junctions (30ab ; 30bc).

6. Photodiode array (200 ; 400 ; 500) according to any one of claims 1 to 5, **characterised in that** the separation region (14 ; 34 ; 54) is separated from the lower face (109 ; 309) of the useful layer by at least one portion (15 ; 35) of said useful layer.

7. Photodiode array (200 ; 400 ; 500) according to any one of claims 1 to 6, **characterised in that** the useful volumes (16 ; 36 ; 56) are spread out in the useful layer (10 ; 30) according to a regular lattice pattern.

8. Photodiode array (200 ; 400 ; 500) according to claim 7, **characterised in that** the useful volumes (16 ; 36 ; 56) are spread out in the useful layer (10 ; 30) according to a square lattice pattern, and separated from each other by a single separation region (14 ; 34; 54).

9. Photodiode array (500) according to any one of claims 1 to 8, **characterised in that** it comprises at least one over-doped zone (550), situated in a region formed by the intersection between a separation region (54) and the doped layer situated on the side of the upper face of the useful layer, designated upper doped layer (50a), the over-doped zone having a doping of type opposite to that of said upper doped layer (50a).

10. Method of manufacturing a planar photodiode array (200 ; 400 ; 500) according to any one of claims 1 to 9, the method comprising the following steps:

    - formation (100 ; 300) of a useful layer (10 ; 30) made of a cadmium, mercury and tellurium semi-conductor alloy of $Cd_xHg_{1-x}Te$ type, comprising at least one PN junction (10ab ; 30ab, 30bc ; 50ab), situated between two superimposed doped layers (10a, 10b ; 30a, 30b, 30c ; 50a, 50b) of the useful layer and which extends over the whole extent of the useful layer;
    - formation (101, 102 ; 301, 302), on the upper face (108 ; 308 ; 508) of the useful layer (10 ; 30), of a layer designated structured layer (121 ; 321) having at least one through opening (120 ; 320), and having a cadmium concentration greater than the average cadmium concentration of the useful layer (10 ; 30);
    - annealing (103 ; 303) of the useful layer (10 ; 30) covered with the structured layer (121; 321), causing a diffusion of cadmium atoms of the structured layer (121; 321), from the structured layer (121 ; 321) to the useful layer (10 ; 30), thereby forming at least one separation region (14 ; 34; 54).

11. Method according to claim 10, **characterised in that** the through openings (120 ; 320) are spread out in the structured layer (121; 321) according to a regular lattice pattern.

12. Method according to claim 10 or 11, **characterised in that** said steps of formation (101, 102 ; 301, 302) of a structured layer (121 ; 321), and annealing (103 ; 303), form a manufacturing cycle, and **in that** at least two manufacturing cycles are implemented.

13. Method according to any one of claims 10 to 12, **characterised in that** the annealing (103 ; 303) is carried out at a temperature comprised between 100°C and 500°C.

14. Method according to claim 13, **characterised in that** the annealing (103 ; 303) is carried out for a duration comprised between 1h and 100h.

15. Method according to any one of claims 10 to 14, **characterised in that** it comprises a doping step, so as to form at least one over-doped zone, situated in a region formed by the intersection between a separation region and the doped layer situated on the side of the upper face of the useful layer, designated upper doped layer, the over-doped zone having a doping of type opposite to that of said upper doped layer.

EP 2 975 643 B1

FIG.1

14

FIG.3

FIG.2

FIG.4

FIG.5

**RÉFÉRENCES CITÉES DANS LA DESCRIPTION**

**Documents brevets cités dans la description**

- US 5880510 A
- EP 2752893 A